# EUROPEAN PATENT APPLICATION

(11) **EP 4 086 639 A1**
(43) Date of publication of application: **09.11.2022**
(21) Application number: 21172626.0
(22) Date of filing: 07.05.2021
(51) Int. Cl.: G01R 13/00, G01D 7/00, G01D 13/20, G02F 1/167

(54) **ELECTRICAL INDICATOR AND METHOD FOR DISPLAYING AN ELECTRICAL VALUE USING A DIGITAL DISPLAY**

(71) Applicant: Tyco Electronics UK Ltd, Wiltshire SN3 5HH (GB)
(72) Inventor: ROBERTS, Jonathan, Dorcan, Swindon, SN3 5HH (GB); JOHNSON, Nigel, Dorcan, Swindon, SN3 5HH (GB); OPALINSKA, Marta Edyta, Dorcan, Swindon, SN3 5HH (GB)
(74) Representative: Grünecker Patent- und Rechtsanwälte PartG mbB

(57) **Abstract**

The present invention relates to an electrical indicator and to a method for displaying an electrical value using an electrical indicator with a reflective display device. The electrical indicator (100) comprises an interface unit for receiving an electrical value to be displayed, and a display unit (104) for displaying the electrical value, wherein the display unit (104) comprises a reflective display device, which has a scale (106) and a pointer (108), the pointer (108) being formed by selectively controllable light reflecting areas of an electronic ink layer.

## Description

The present invention relates to an electrical indicator and to a method for displaying electrical values using an electrical indicator with a digital display device.

Electrical indicators are used for a wide range of applications such as voltmeters, ammeters and wattmeters for AC/DC switchgears, panels, and distribution boards, control boards, or generator sets.

As this is known in the art, conventional electrical measuring devices for measuring electricity (voltmeters, ammeters, frequency meters) operate by inducing a current in a magnetic field which causes a pointer to move relative to the applied signal. The devices can be used in all system configurations (single-phase and three-phase).

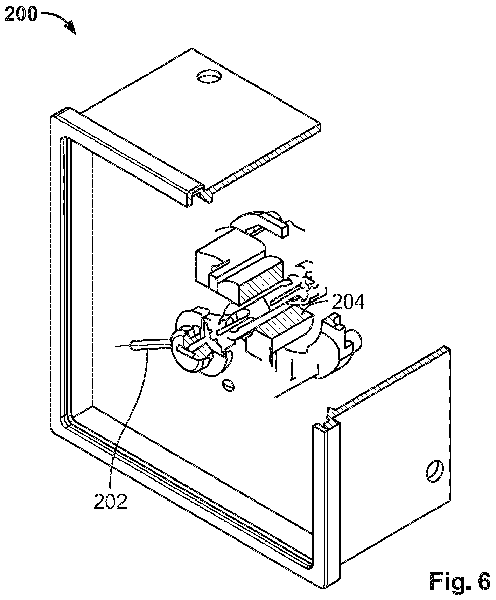

In any case, known electrical measurement devices usually have electrical indicators as schematically shown in Fig. 6. In particular, the conventional electrical indicator 200 comprises a mechanical pointer 202, which is moved according to the measurement value to be displayed. A scale (not shown in the Figure) is provided as a dial with the scale printed thereon. The movement of the mechanical pointer 202 is performed by means of a mechanical pointer drive 204. The mechanical pointer drive 204 comprises coils, magnets, and bearings which are sensitive to mechanical shock, so that it is difficult to ensure an accurate result when used in high shock environments. The assembly of the conventional mechanism 200 needs highly skilled personnel and a complex supply chain. The scale has to be prefabricated and has no flexibility regarding the shown markings and partitioning.

Consequently, there is still a need for an improved electrical indicator which is suitable for high shock environments, has a high flexibility towards customer demands and can be fabricated in a fast and economic manner.

This object is solved by the subject matter of the independent claims. Advantageous embodiments of the present invention are the subject matter of the dependent claims.

The present disclosure is based on the idea to dispense with any mechanically moving parts and to use a display unit with a reflective electrophoretic ink layer to represent the pointer. The advantage of this solution is that electrical indication can be provided even in high shock environment. As no mechanically moving parts are used, less scrap is produced during manufacturing and assembly, and a robust and accurate display can be achieved which is not susceptible to high external impacts. Moreover, due to the bi-stable characteristics of reflective electrophoretic ink, no energy needs to be provided for keeping the pointer in a particular constant position.

In particular, the present disclosure provides an electrical indicator comprising an interface unit for receiving a value to be displayed, and a display unit for displaying the value, wherein the display unit comprises a reflective display device, which has a scale and a pointer, the pointer being formed by selectively controllable light reflecting areas of an electronic ink layer.

The electronic ink layer is for instance formed by a reflective electrophoretic ink layer which as such is known in the art. In particular, electrophoretic ink (also referred to as E Ink) is a proprietary technology developed by the E Ink Corporation that mimics the appearance of ink on paper. Because electrophoretic ink makes use of reflected light to show an image, it works well with an external light source, like a light bulb or direct sunlight. Displays using electrophoretic ink consume minimal energy.

Electrophoretic ink technology makes use of tiny capsules called microcapsules, which contain a clear fluid as well as tinier black and white particles. When an electric field is applied to such a microcapsule, the negatively charged black particles move in one direction, while the positively charged white particles go the other. Once the particles are in place, they lay suspended even when the electric field is removed. When the electric field is reversed, the particles exchange places. They stay suspended there on either side of each other even when the electric field is removed. This characteristic is called bi-stable behavior and allows the microcapsule to use almost no energy while the particles are suspended.

A large number of these microcapsules make up the entire surface of a typical electrophoretic ink display. For the present application, for instance a 600 x 600 pixels matrix may be suitable. However, any other desired size may also be used. Because each microcapsule can be exposed to a different electric field direction or polarity, it is possible to come up with a combination of electric field directions to show correspondingly different combinations of black and white on the exposed side of the display. In modern versions of the electrophoretic ink displays, also color images can be displayed by applying additional suitable color filters.

As already mentioned, the solution according to the present disclosure has the advantage that a highly shock resistant electrical instrument with low power consumption of the display may be provided. Furthermore, the pointer and scale are easy to read and the electrophoretic ink representation of the pointer allows a precise display of virtually any position angle of the pointer, by closely mimicking an analogue pointer. In contrast to a mechanical pointer, no parallax error can occur when reading the pointer position. Depending on the input variables of the electrical indicator, also more than one pointer can be displayed, each indicating another parameter. The visibility is high under low light conditions as well as in the direct sunlight.

Moreover, the supply chain and manufacturing process can be simplified.

When also representing the scale by selectively controllable light reflecting areas of the electronic ink layer, the scale is advantageously customer configurable.

The interface unit advantageously allows a digital communication using any suitable communication protocol, including Bluetooth^{™} or Modbus^{™}. Of course, any other protocol may also be used as required by the particular application environment.

Advantageously, the interface unit comprises a plug connector for a wire bound connection to a electrical measuring device. In this manner, a direct and accurate transfer of the measurement value to be displayed can be affected. It has be noted that the measurement value may either be the completely processed digital value, or may also be an analogue value of the voltage and current, so that the electrical indicator has an integrated evaluation and control unit which performs the conversion into a digital value which can be input into the display unit.

Additionally or alternatively, the interface unit may comprise a wireless communication unit. Such a wireless communication unit may for instance support Bluetooth^{™} , Modbus^{™}, or wireless local area network (WLAN) communication under IEEE 802.11 a/b/g. As wireless communication technology is well-established and known in the art, no further details will be given here. The advantage of a wireless communication unit can be seen in the fact that the electrical indicator may be accessed without physically touching the measurement site. Furthermore, in addition to a visual reading of the pointer, also a remote storing of the measurement values is possible.

According to an advantageous example of the present disclosure, the electrical indicator further comprises an electronic control unit (ECU) for controlling the display unit based on the received electrical value. This ECU firstly controls the individual pixels of the electronic ink layer to show a particular image. As this is generally known, this control comprises addressing individual electrodes to build up the desired image. Usually, the addressing is performed in a scanning manner. According to the present disclosure, the ECU may also be operable to compare the pointer image which is to be displayed to a currently displayed pointer image and to determine those pixels which have to be changed in their status in order to display the new pointer image. Then, only the pixels which have to change their status need to be addressed, which reduces energy consumption and reaction time.

According to an advantageous example of the present disclosure, the electrical indicator comprises a memory for storing pointer images associated with electrical values. Thus, the control of the display unit can be facilitated and the reaction time to a change in the pointer position needed can be shortened.

According to an advantageous example of the present disclosure, the display unit comprises illumination means for illuminating the scale and the pointer. Thus, the pointer position can also be easily read under low light conditions.

As already mentioned above, the scale may also be formed by selectively controllable light reflecting areas of the electronic ink layer. Thereby, also the image of the scale is electronically controllable and can be adapted to the respective needs of the application environment. In particular, the end scale values may individually be chosen.

For adapting the displaying of the scale, the electrical indicator may further comprise input means for controlling displaying the scale. These input means may comprise direct manual input means such as input keys or a touch sensitive section of the display unit's surface. Alternatively or additionally, the input means may be a part of the interface unit so that the displaying of the scale may be controlled remotely, or may be automatically adapted to a received electrical value.

The present disclosure further relates to a method for displaying an electrical value using an electrical indicator with a reflective display device, which has a scale and a pointer, the method comprising the following steps:
receiving an electrical value to be displayed;
determining a pointer position corresponding to the electrical value to be displayed;
retrieving a pointer image corresponding to the pointer position from a memory; and
controlling the reflective display device to display the pointer image, the pointer being formed by selectively controllable light reflecting areas of an electronic ink layer.

According to an advantageous example of the present disclosure, the method further comprises the step of determining whether a currently received second value differs from a preceding first value, and retaining the pointer image displayed for the preceding value, if the first and second values do not differ from each other. Thereby, the display pixels do not have to be addressed or refreshed in case no change in the measurement value has occurred. The power consumption of the electrical indicator can thus be kept low.

According to an advantageous example of the present disclosure, the method further comprises the steps of
determining a pixel array of the current pointer image,
comparing the pixel array to the pixel array of the preceding pointer image and determining the pixels that have to be controlled to change their status for displaying the new pointer image,
controlling only the pixels determined in the comparison step to change the charging of the associated ink particles.

This concept allows to change the pointer position with minimal energy consumption and reduces the response time to a change in the electrical value.

For enhancing visibility under low light conditions, the method may further comprise the step of illuminating the scale and pointer. This may for instance be done by using an LED low power lighting module.

In order to facilitate characterizing the pointer image to be displayed, the pointer position comprises a value for an angle which a longitudinal axis of the pointer includes with a horizontal reference axis of the scale.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- **FIG. 1**: is a schematic perspective representation of a electrical indicator according to an advantageous example of the present disclosure;
- **FIG. 2**: is a partly opened and exploded schematic illustration of the electrical indicator of Fig. 1;
- **FIG. 3**: is a schematic top view of a display module;
- **FIG. 4**: is a schematic side view of the display module;
- **FIG. 5**: is a schematic flow chart illustrating a method of displaying measurement results;
- **FIG. 6**: is a schematic perspective representation of a conventional electrical indicator.

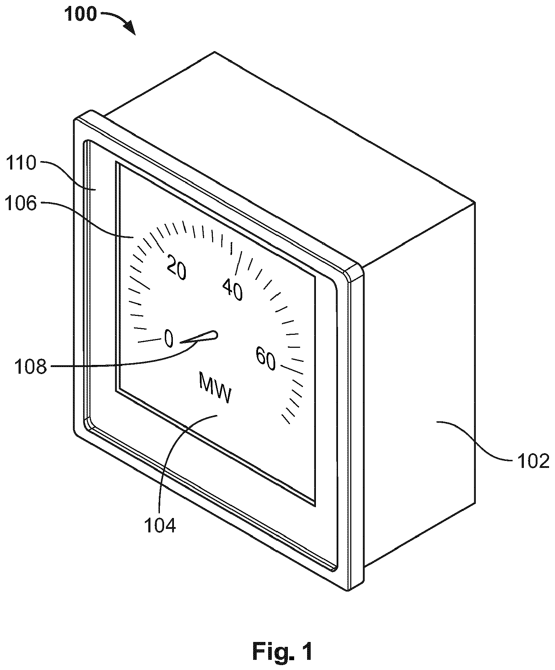

The present invention will now be explained in more detail with reference to the Figures and firstly referring to Fig. 1. Figure 1 shows a perspective view of a electrical indicator 100 according to the present disclosure. In the shown example, the electrical indicator 100 is a power indicator. It is, however, clear that any other electrical parameter, such as voltage and/or current, may be displayed in addition or alternatively to the electrical power.

As shown in Fig. 1, the electrical indicator 100 has a housing 102, in which a display unit 104 is arranged so that a scale 106 and a pointer 108 are visible. The display unit 104 comprises a reflective electrophoretic ink technology display module based on an active matrix thin film transistor (TFT) substrate. It may for instance have a 3.84 inches active area with 600 x 600 pixels. The display is for instance capable of displaying images at 2 to 8 gray levels (1 to 3 bits). Advantageously, the electrophoretic ink technology display unit has a high reflectance with an ultra-wide viewing angle and an ultralow power consumption. The display is bi-stable, meaning that energy has only to be used for changing the state of each pixel, but not for maintaining the pixel in the respective state.

According to the present example, a front light module (not visible in the Figure) is arranged behind the front frame 110 in order to illuminate the scale 106 and the pointer 108 from the front. Thus, the electrical indicator 100 is easily readable also with no or low light in the environment.

Advantageously, when reading the position of the pointer 108, no parallax error can occur because the pointer is physically arranged within the same plane as the scale. Furthermore, in the shown example, the scale 106 is in MW with a maximum value of 70 MW. However, the appearance of the scale can easily be modified by accordingly controlling the display unit 104. Moreover, it is clear that the scale may also be just a passive printed part on the surface of the display unit 104. In this case, the active area of the display unit 104 may actually be smaller, thus reducing the costs of the display unit 104.

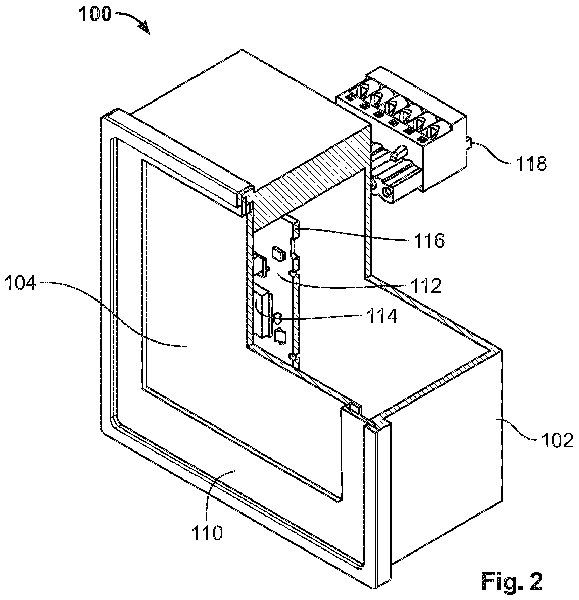

Fig. 2 illustrates a partly opened perspective view of the electrical indicator 100 of Fig. 1. Inside the housing 102, an electronic control unit (ECU) 112 is arranged. The ECU 112 comprises the electronic circuits and components 114 which are needed for controlling the display unit 104. The electronic circuits and components 114 are assembled on a printed circuit board (PCB) 116.

For connecting the electrical indicator 100 to a measurement device (not shown in the Figure), a connector 118 is provided. Additionally or alternatively, the electronic control unit 112 may be equipped with a wireless communication interface. For instance, a wireless communication unit may for instance support Bluetooth^{™}, Modbus^{™}, or wireless local area network (WLAN) communication under IEEE 802.11 a/b/g. The advantage of a wireless communication unit can be seen in the fact that the electrical indicator may be accessed without physically touching the measurement site. Furthermore, in addition to a visual reading of the pointer, also a remote storing of the measurement values is possible.

On the other hand, the measurement circuitry which is needed for measuring the voltage and the current, may also be integrated within the housing 102 of the electrical indicator 100.

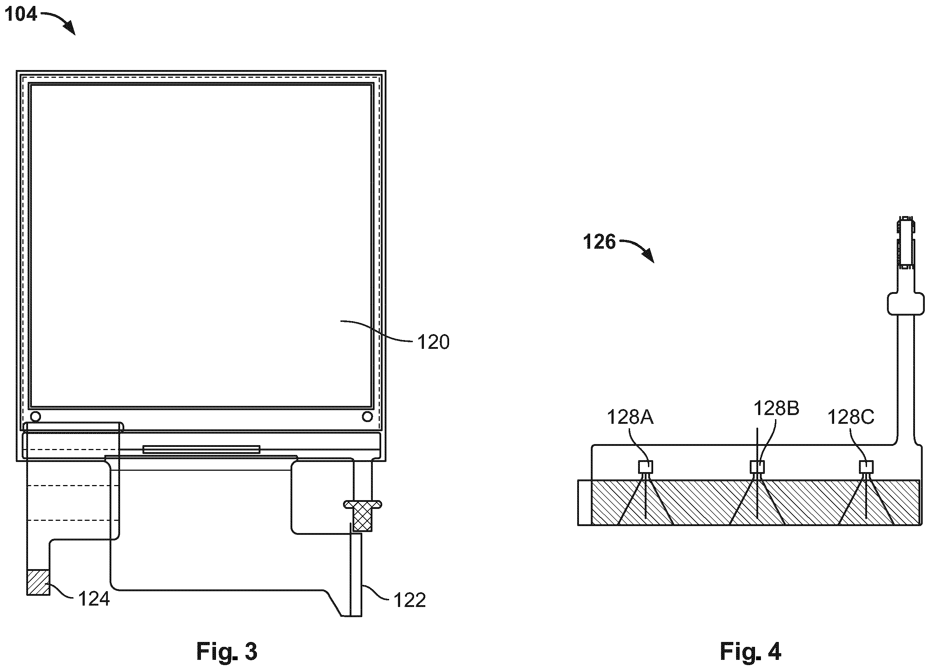

Fig. 3 illustrates a plan view of the display unit 104 before being mounted inside the housing 102 of the electrical indicator 100. Reference numeral 120 indicates the active area of the reflective electrophoretic ink display. Electric connectors 122 and 124 are connected to the electronic control unit 112 for controlling the individual pixels of the display unit.

According to the present example, the active area has dimensions of 69 mm x 69 mm. The pixel pitch is 0.115 mm x 0.115 mm. However, these dimensions are of course arbitrary examples and any other electronic ink display may also advantageously be used. In particular, when using a printed version of the scale 106 instead of displaying the scale 106 together with the pointer 108, a smaller active area is sufficient.

As mentioned above, the electrical indicator 100 may comprise a lighting unit for ensuring visibility of the pointer and scale in case of an insufficiently lighted environment. Fig. 4 shows an example of an LED lighting unit 126 according to the present example. The lighting unit 126 comprises three light emitting diodes (LEDs) 128A, 128B, and 128C. The lighting unit 126 is arranged behind the frame 110 and illuminates the active surface 120 from the tangentially from the side. The lighting unit 126 may either be always active or only if switched on, for instance when low external light is sensed. Of course, also more than one lighting unit 126 may be mounted behind the frame 110.

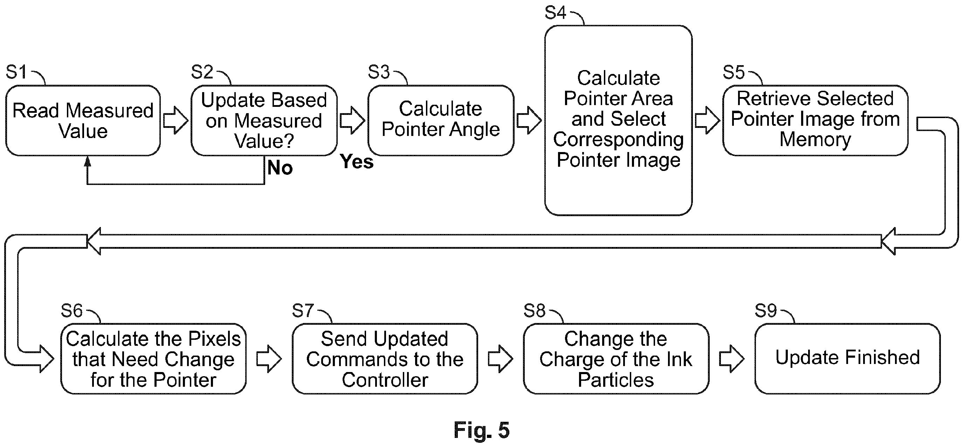

A method of operating the electrical indicator 100 according to the present disclosure will be explained in more detail with reference to the flow diagram shown in Fig. 5.

The process starts with step S1, where the electrical value is read via the communication interface. In step S2, it is decided whether an update of the pixel states is needed based on the measured value. In other words, it is decided whether the new measured value differs from a previous measured value which is displayed at the moment. If the answer is "NO", the process returns to step S1, if the answer is "YES", the pointer angle is calculated.

According to the present disclosure, the pointer angle is the angle that a longitudinal axis of the pointer 108 includes with a horizontal axis passing through the midpoint of the scale 106 shown in Fig. 1 (step S3).

In step S4, the pointer area is determined; in other words those pixels which have to be activated to be visible, and a corresponding pointer image is selected. This selected pointer image is retrieved from a memory which is part of the electronic control unit (ECU) 112. From a comparison between a currently displayed pointer image and the pointer image corresponding to the newly read electrical value, in step S6 those pixels are calculated which need to change their in order to display the correct pointer angle.

In step S7, updated commands are sent to the controller IC which controls the operation of the display unit. Consequently, the charge of the particles is changed only for those pixels which need to change their state in order to display the new angle of the pointer 108.

In step S8 the update of the pointer representation is finished and the process returns to step S1.

In summary, the present disclosure provides a electrical indicator which can be used in high shock environments and has an easy to read pointer and scale. A single parameter indication is possible. Advantageously, the scale may be customer configurable. Digital communication may be performed using proprietary protocols including Bluetooth^{™} or Modbus^{™} (other protocols are also possible). The pointer and scale are highly visible in low light and in direct sunlight. The power consumption is extremely low and the supply chain and manufacturing process are simplified compared to known mechanical solutions.

**REFERENCE NUMERALS**

| **Reference Numeral** | **Description** |
|---|---|
| 100 | electrical indicator |
| 102 | housing |
| 104 | display unit |
| 106 | scale |
| 108 | pointer |
| 110 | front frame |
| 112 | electronic control unit (ECU) |
| 114 | electronic circuits and components |
| 116 | printed circuit board (PCB) |
| 118 | plug connector |
| 120 | active area |
| 122 | first electric connector |
| 124 | second electric connector |
| 126 | lighting unit |
| 128A, 128B, 128C | LED |
| S1 - S8 | process steps |
| 200 | conventional electrical indicator |
| 202 | mechanical pointer |
| 204 | mechanical pointer drive |

## Claims

1. Electrical indicator comprising:
an interface unit for receiving an electrical value to be displayed, and
a display unit (104) for displaying the electrical value, wherein the display unit (104) comprises a reflective display device, which has a scale (106) and a pointer (108), the pointer (108) being formed by selectively controllable light reflecting areas of an electronic ink layer.

2. Electrical indicator according to claim 1, wherein the interface unit comprises a plug connector (118) for a wire bound connection to an electrical measuring device.

3. Electrical indicator according to claim 1 or 2, wherein the interface unit comprises a wireless communication unit.

4. Electrical indicator according to one of the preceding claims, further comprising an electronic control unit (112) for controlling the display unit (104) based on the received electrical value.

5. Electrical indicator according to one of the preceding claims, further comprising a memory for storing pointer images associated with electrical values.

6. Electrical indicator according to one of the preceding claims, wherein the display unit (104) comprises illumination means (126) for illuminating the scale (106) and the pointer (108).

7. Electrical indicator according to one of the preceding claims, wherein the scale (106) is also formed by selectively controllable light reflecting areas of the electronic ink layer.

8. Electrical indicator according to one of the preceding claims, further comprising input means for controlling displaying the scale (106).

9. Method for displaying a electrical value using an electrical indicator with a reflective display device, which has a scale (106) and a pointer (108), the method comprising the following steps:
receiving an electrical value to be displayed;
determining a pointer position corresponding to the electrical value to be displayed;
retrieving a pointer image corresponding to the pointer position from a memory; and
controlling the reflective display device to display the pointer image, the pointer being formed by selectively controllable light reflecting areas of an electronic ink layer.

10. Method according to claim 9, further comprising the step of determining whether a currently received electrical value differs from a preceding electrical value, and retaining the pointer image displayed for the preceding electrical value.

11. Method according to claim 9 or 10, further comprising the steps of
determining a pixel array of the current pointer image,
comparing the pixel array to the pixel array of the preceding pointer image and determining the pixels that have to be controlled to change their status for displaying the new pointer image,
controlling only the pixels determined in the comparison step to change the charging of the associated ink particles.

12. Method according to one of the claims 9 to 11, wherein the method further comprises the step of illuminating the scale (106) and pointer (108).

13. Method according to one of the claims 9 to 12, wherein the pointer position comprises a value for an angle which a longitudinal axis of the pointer includes with a horizontal reference axis of the scale.

14. Method according to one of the claims 9 to 13, wherein the scale (106) is also formed by selectively controllable light reflecting areas of the electronic ink layer.

15. Method according to one of the claims 9 to 14, wherein displaying the scale (106) can be controlled by an external input received by the electrical indicator.
